(19) Europäisches Patentamt
European Patent Office
Office européen des brevets

(11) **EP 0 961 399 B1**

(12) **EUROPEAN PATENT SPECIFICATION**

(45) Date of publication and mention
of the grant of the patent:
**25.11.2009 Bulletin 2009/48**

(51) Int Cl.:
***H03D 7/16*** (2006.01)

(21) Application number: **99304158.1**

(22) Date of filing: **28.05.1999**

(54) **Multiple conversion radio receivers**

Funkempfänger mit mehreren Umsetzern

Récepteurs radio comprenant plusieurs convertisseurs

(84) Designated Contracting States:
**BE DE ES FR IT NL**

(30) Priority: **29.05.1998 GB 9811681**

(43) Date of publication of application:
**01.12.1999 Bulletin 1999/48**

(73) Proprietor: **BRITISH BROADCASTING CORPORATION**
**Tadworth, Surrey KT20 6NP (GB)**

(72) Inventor: **Robinson, Adrian Paul**
**London W14 0RH (GB)**

(74) Representative: **Robson, Aidan John**
**Reddie & Grose**
**16 Theobalds Road**
**London**
**WC1X 8PL (GB)**

(56) References cited:
**EP-A- 0 660 507      US-A- 5 390 346**
**US-A- 5 610 559**

• **PATENT ABSTRACTS OF JAPAN vol. 016, no. 403 (E-1254), 26 August 1992 (1992-08-26) & JP 04 133508 A (MITSUBISHI ELECTRIC CORP), 7 May 1992 (1992-05-07)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

This invention relates to multiple conversion radio receivers.

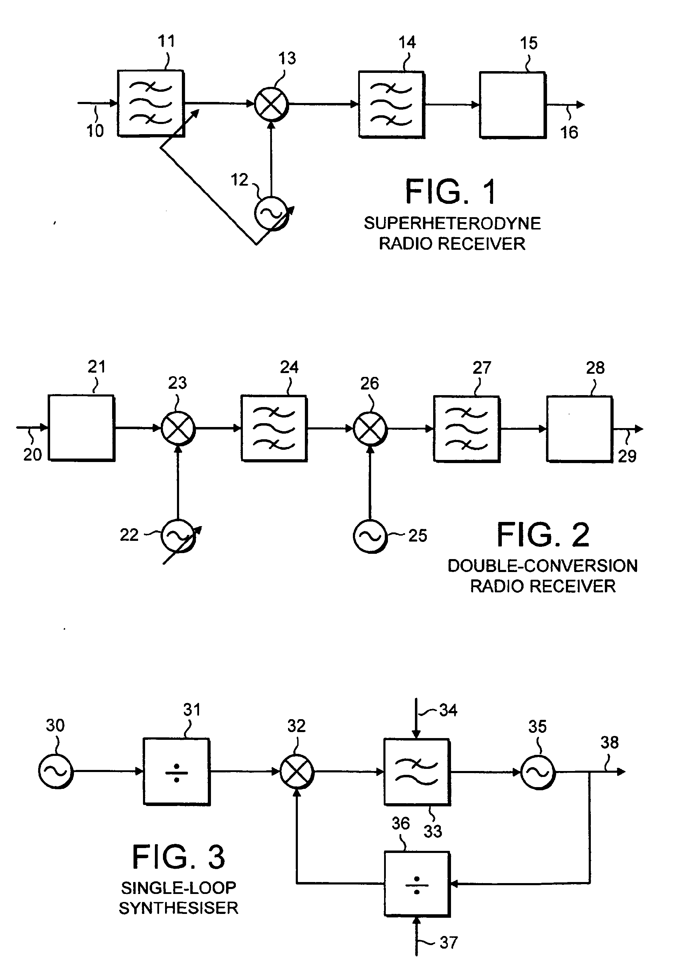

The principles of a superheterodyne radio receiver, shown in Figure 1, are well known. So we just note here the functions of the various parts. 10 is the input; 11 is a tunable bandpass filter tuned to the frequency of the input signal; 12 is a tunable local oscillator tuned to a frequency different than that of the input signal by an amount equal to the intermediate frequency; 13 is a mixer; 14 is a bandpass filter centred on the intermediate frequency; 15 is a demodulator or other processor which extracts the information carried by the input signal; and 16 is the output. An example of a radio receiver, which operates on these principles, is disclosed in US Patent No. 5610559.

A development of this is the double-conversion receiver, shown in Figure 2. This avoids the difficulties associated with getting the tuning of bandpass filter 11 to track the tuning of local oscillator 12, and it can give better image rejection. Again, the principles are well known so we just note the functions of the various parts. 20 is the input. 21 is a filter whose passband encompasses the range of frequencies to be received. 22 is the first local oscillator, which is tunable and is tuned to a frequency different than that of the input signal by an amount equal to the first intermediate frequency, which is not equal to any frequency to be received. 25 is the second local oscillator, which is at a frequency different than the first intermediate frequency by an amount equal to the second intermediate frequency. 26 is the second mixer. 27 is a bandpass filter centred on the second intermediate frequency. 28 is a demodulator or other processor which extracts the information carried by the input signal. 29 is the output. An example of such a receiver is shown in US Patent No. 5390346.

In many present-day receivers, e.g., consumer tuners for television, the local oscillator(s) comprise a single-loop synthesiser. Tuning of the local oscillator is obtained by programming the synthesiser to produce frequencies in small increments or steps. The principles of the synthesiser, shown in Figure 3, are well known, so again we just note the functions of the various parts. 30 is the reference frequency source which is usually a crystal oscillator. 31 is a divider which divides the reference frequency to give the comparison frequency; the division ratio may be programmable but it is usually kept constant. 32 is a phase or phase-frequency detector. 33 is the loop filter; its characteristics are chosen to make the loop stable and to optimise the performance of the synthesiser. The loop filter may have a programming input 34 to change its characteristics according to the frequency being synthesised. 35 is a voltage-controlled oscillator. 36 is a programmable divider whose division ratio is set via input 37 to choose the frequency that will be synthesised. 38 is the output.

An example of such a synthesizer is shown in US-A-5390346.

The frequency produced by the synthesiser is $nf_c$, where $n$ is the division ratio of programmable divider 36 and $f_c$ is the comparison frequency. $n$ is necessarily an integer, thus the smallest possible frequency step of the synthesiser is $f_c$ unless a more elaborate design is used.

In some applications it is important that the amount of phase noise on the local oscillator should be small. In the kind of synthesiser we are considering, there are two main sources of phase noise. The first source is the phase noise of the free-running voltage-controlled oscillator. This noise generally falls with increasing frequency offset, ultimately reaching a plateau, and it largely determines the phase noise of the synthesiser at offset frequencies outside the loop bandwidth. The second source of phase noise is noise in the phase detector and possibly on the output of the dividers which feed it. This noise tends to be white and it largely determines the phase noise of the synthesiser at offset frequencies within the loop bandwidth. Thus, the optimum choice of loop bandwidth, as far as overall phase noise is concerned, is near the frequency at which the two sources of noise are equal in level.

The phase noise density of the synthesiser at offset frequencies within the loop bandwidth is proportional to $n^2$. Thus, the phase noise can be reduced by reducing $n$. For a given output frequency, this means increasing the comparison frequency and hence the step size. (Whereupon the optimum loop bandwidth also increases.) But it can be seen that with this simple, low-cost design it is not possible to have both low phase noise and a small step size.

The invention is defined in the appended claims to which reference should now be made.

The invention will now be described in detail by way of example with reference to the accompanying drawings in which:

**Figure 1** shows a known superheterodyne radio receiver as referred to above;
**Figure 2** shows a double-conversion radio receiver as referred to above;
**Figure 3** shows a single loop synthesiser as referred to above;
**Figure 4** shows a flow diagram for calculation of parameters $k$ and $l$ for use in an embodiment of the invention; and
**Figure 5** shows an alternative flowchart for calculation of parameters $k$ and $l$.

We have appreciated that - in a double-conversion receiver - the phase noise for a desired small overall step size can be reduced as follows. Both the first and second local oscillators are made tunable and comprise single-loop synthesisers. The step sizes in the two synthesisers are made mutually-prime (integer) multiples of the desired small overall step size. The larger step sizes allow the total phase noise of the two synthesisers to be less than the phase noise of one synthesiser which has a step size equal to the desired small step size.

Mutually-prime means that the integers have no common factor except unity. The use of such multiples of the desired small step size, ensures that the receiver can be tuned to all of the desired small steps by appropriate choice of the frequencies of the two local oscillators. It will often be convenient to choose a successive pair of integers for the multiples, e.g., 5 and 6, because successive integers are always mutually-prime. However, we have also appreciated that this is not essential, e.g., 5 and 8, which are mutually-prime but non-successive, may be used for the multiples.

The effect of this is that the first intermediate frequency (i.f.) is not fixed, but will depend on the frequency to which the receiver is tuned. Thus, the first i.f. filter will need to have a bandwidth wider than the signal being received, but this will not normally be a problem. Let us use the symbols $\Delta$ for the desired small step size and $p$ and $q$ for the aforementioned multiples. More specifically, let the step sizes of the first and second local oscillators be $p\Delta$ and $q\Delta$ respectively. Then the first i.f. will fall at one of a set of p frequencies at intervals of $q\Delta$. So the range of variation of the first i.f. will be $(p - 1)q\Delta = (pq - q)\Delta$. Thus, by making q the greater of the two multiples, the range of variation of the first i.f. can be minimised. The second local oscillator only needs to be tuned over a narrow range, equal to the range of variation of the first i.f. It may be possible to exploit this fact to reduce the amount of phase noise on this oscillator. It is advantageous to share the reference frequency source between the synthesisers, but this is not essential. If the reference frequency source is to be shared, its frequency must be $pq\Delta$, or an integer multiple of this.

The choice of intermediate frequencies is not completely free. The set of frequencies to be received is, by definition, the set of frequencies from the lowest frequency to be received, at intervals of $\Delta$ up to the highest frequency to be received, or a subset of this. For the general case where the frequencies to be received are not necessarily integer multiples of $\Delta$, let $\delta$ be the amount by which the frequencies to be received differ from integer multiples of $\Delta$, where $(0 \leq \delta < \Delta/2)$. That is,

$$f = m\Delta \pm \delta$$

where $f$ is the frequency of the input signal and $m$ is an integer.

Then both the first i.f. and the second i.f. must differ from some integer multiple of $\Delta$, by an amount equal to $\delta$. That is,

$$if_1 = m\Delta \pm \delta, \quad if_2 = n\Delta \pm \delta$$

where $if_1$ is the first i.f., $if_2$ is the second i.f. and $m$ and $n$ are integers. (The frequencies of the input signal, the first i.f. and the second i.f. are all measured in the same way, e.g. to the carrier frequency of the signal or to the centre frequency of the signal.)

Let $lo_2$ be the frequency of the second local oscillator.

Then the choice of i.f.s is further constrained by

$$if_1 \pm if_2 = mq\Delta$$

where

"+" is to be taken if $lo_2 > if_1$,
"-" is to be taken if $lo_2 < if_1$,
and $m$ is an integer.

This is because

$$if_1 \pm if_2 = lo_2,$$

where the sign is chosen as above.

Let $f_1$ be the centre of the range of variation of the first i.f.
then, if $p$ is odd, $if_1 \pm if_2 = mq\Delta$
and if $p$ is even, $if_1 \pm if_2 = hq\Delta /2$ where

$m$ is an integer,
$h$ is an odd integer,

and the sign is chosen as before.

Thus, one of $if_1$ and $if_2$ is constrained to be chosen from frequencies at intervals of $\Delta$ and the other at intervals of $q\Delta$.

By way of example, suppose that the step size ($\Delta$) is 0.16 MHz, that the frequencies to be received differ by ($\delta$) 0.05 MHz from integer multiples of $\Delta$, that $if_1$ is to be near 1220 MHz, $if_2$ is to be near 36.15 MHz, the second local oscillator frequency is to be lower than the first i.f., and the multiples $p$ and $q$ are 4 and 5 respectively. Let us choose $if_2$ from frequencies at intervals of $\Delta$. Then $if_2$ must be 0.05 MHz different than a multiple of 0.16 MHz and the nearest such frequency to 36.15 MHz is 36.116 MHz (the multiple being 217). $if_1 - if_2$ must be some odd integer multiple of 5 x 0.16/2 MHz, because $p$ is even. Thus, $if_1$ must be equal to 36.116 MHz plus some odd integer multiple of 0.416 MHz and the nearest such frequency to 1220 MHz is 1219.86 MHz (the multiple being 2841). The range of variation of the first i.f. is $if_1 \pm (p - 1)q\Delta/2$, i.e. from 1218.616 MHz to 1221.116° MHz. These two frequencies are designated $f_a$ and $f_b$ respectively. The shared reference frequency, if used, would be 3.3 MHz or a multiple of this. This example is summarised in Table 1 below, where a second example is also given. $m$ in the table is an integer.

**Table 1. Choice of intermediate frequencies and other parameters.**

|  | 1st Example | 2nd Example |
|---|---|---|
| $\Delta$ | 0.16 MHz | 0.16 MHz |
| $\delta$ | 0.05 MHz | 0 |
| $if_1 \approx$ | 1220 MHz | 1220 MHz |
| $if_2 \approx$ | 36.15 MHz | 36.15 MHz |
| $lo_2 > if_1$? | No | No |
| $p$ | 4 | 5 |
| $q$ | 5 | 8 |
| Intervals of $\Delta$ for | $if_2$ | $if_2$ |
| $if_2$ | 36.116 MHz | 36.16 MHz |
| $if_1$ | 1219.86 MHz | 1220.16 MHz |
| $f_a$ | 1218.616 MHz | 1217.5 MHz |
| $f_b$ | 1221.116 MHz | 1222.83 MHz |
| Shared ref. freq. | $m$ x 3.3 MHz | $m$ x 6.6 MHz |

We can now complete the explanation of why it is possible to tune the receiver to all of the desired small steps. It can be seen that the choice of parameters as described above will ensure that the second local oscillator frequency only needs to be a multiple of $q\Delta$ and the first local oscillator frequency ($lo_1$) only needs to be a multiple of $p\Delta$. It remains to explain why $lo_1$ only needs to be a multiple of $p\Delta$. $lo_1$ will be a multiple of $p\Delta$ if $((lo_1/\Delta) \bmod p) = 0$. Now as noted above, the first i.f. falls at one of $p$ possible frequencies at intervals of $q\Delta$. For a given $f$, there is a corresponding set of $p$ candidate values for $lo_1$. But by the properties of mutually-prime numbers (the Chinese Remainder Theorem), the corresponding $p$ values of $((lo_1/\Delta) \bmod p)$ will all be different and will therefore encompass all the integers from 0 to $p - 1$. So $lo_1$ can always be a multiple of $p\Delta$, as desired.

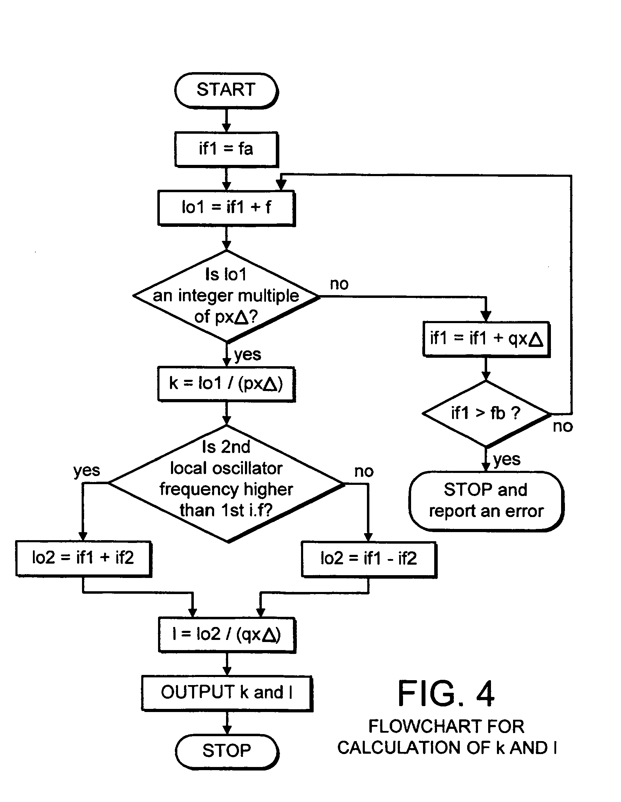

The required division ratios for divider 36 in the two synthesisers can be calculated as shown in the flow chart, Figure 4. Note that this is not necessarily the only, or even the best way to find the division ratios. The division ratios are designated k and $l$ for the first and second local oscillators respectively. $f$ is the frequency of the input signal, as above. Before the flow chart is used, the following parameters need to have been chosen: $p, q, f_a, f_b, if_2$ and whether the second local oscillator frequency is to be higher or lower than the first i.f.

The calculations can be simplified to use integer arithmetic by:

(a) subtracting $\delta$ from $f$ and adding $\delta$ to $f_a$, $f_b$ and $if_2$ (replacing $f$, $f_a$, $f_b$ and $if_2$ with their new values);
(b) (optionally) adding to or subtracting from $f$ some integer multiple of $\Delta$ and, respectively, subtracting from or adding to $f_a$, $f_b$ and $if_2$ the same integer multiple of $\Delta$ (further replacing $f$, $f_a$, $f_b$ and $if_2$ with their new values);
(c) dividing $f$, $f_a$, $f_b$ and $if_2$ by $\Delta$. Call these integer values $f'$, $f_a'$, $f_b'$ and $if_2'$.

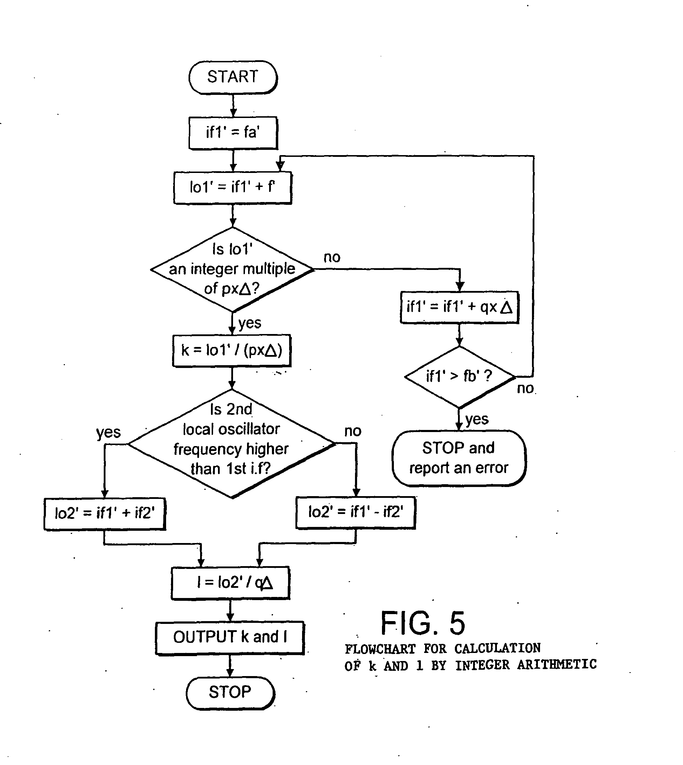

The division ratios can then be calculated as shown in the flow chart of Figure 5.

In Table 2 below, we suppose some values for $f$ and continue the examples of Table 1. The values of $k$ and $l$ in Table 2 were found from the flow chart of Figure 4.

**Table 2. Division ratios and other parameters for a given input frequency.**

|  | **1st Example** | **2nd Example** |
|---|---|---|
| $f$ | 530.216 MHz | 530.16 MHz |
| $k$ | 2627 | 2102 |
| $l$ | 1422 | 889 |
| $lo_1$ | 1751.3 MHz | 1751.6 MHz |
| $if_1$ | 1221.116 MHz | 1221.5 MHz |
| $lo_2$ | 1185 MHz | 1185.3 MHz |

The required division ratios for the two synthesisers, as a function of the input frequency, could be calculated as required by logic circuits or by suitable software running on a suitable processor. However, if $f$, $f_a$, $f_b$ and $if_2$ is a recurring decimal fraction (if the numbers are represented in decimal) or a recurring binary fraction (if the numbers are represented in binary), this will cause complications because operations such as "approximately equal to" and "definitely greater than" will be required. It may then be preferable to adopt the integer arithmetic approach described above. Another possibility would be to calculate the division ratios in advance and store them in a memory to be accessed as required.

A number of variations on this idea are possible. For example, triple or higher-order conversion could be used, with any two or more of the local oscillators being tuned in the manner described to give the desired frequency of reception.

This invention could also be used to give a wider range of choices for the second i.f. in a double-conversion receiver. This would permit the re-use of an existing filter design in a new receiver when the frequency of the filter is not sufficiently close to one of the frequencies $n\Delta - \delta$. This would be done by designing the receiver for a smaller step size of $\Delta/m$ where $m$ is an integer, so allowing the choice of the second i.f. from among a more closely-spaced set of frequencies. The invention is beneficial, for example, when the phase noise of the synthesiser would be too high at a step size of $\Delta/m$.

**Claims**

1. A multiple conversion radio receiver comprising at least first and second local oscillators (22, 25) for converting an input signal (20) to respective first and second intermediate frequencies, wherein each local oscillator is a single 'loop synthesiser (30-38) which can be tuned in predetermined minimum frequency step sizes and the minimum frequency step sizes in the two oscillators are non-successive mutually prime multiples of an overall frequency step size for the radio receiver.

2. A multiple conversion radio receiver according to claim 1 comprising a first frequency filter (21) coupled to an input (20) and having a bandwidth greater than that of the signal (20) being received.

3. A multiple conversion radio receiver according to claim 1 or 2 in which the single loop synthesisers (31-38) share a common reference frequency source (30).

4. A multiple conversion radio receiver according to claim 1, 2 or 3 in which there are two local oscillators.

5. A method for receiving a radio signal with a multiple conversion radio receiver comprising the steps of converting an input signal to at least first and second intermediate frequencies by mixing the signal with signals from respective first and second local oscillators, wherein the local oscillators are single loop synthesisers which can be tuned in predetermined minimum frequency step sizes, and further comprising the art of determining the frequency step sizes of first and second local oscillators by making them non-successive mutually prime multiples of an overall frequency step size for the radio receiver.

**Patentansprüche**

1. Mehrfach-Überlagerungsfunkempfänger, umfassend mindestens einen ersten und einen zweiten örtlichen Oszillator (22, 25) zum Wandeln eines Eingangssignals (20) zu einer ersten bzw. einer zweiten Zwischenfrequenz, wobei es sich bei den örtlichen Oszillatoren jeweils um Einschleifensynthesizer (30-38) handelt, die in vorherbestimmten Mindestfrequenzschrittgrößen abgestimmt werden können und die Mindestfrequenzschrittgrößen in den zwei Oszillatoren nicht aufeinanderfolgende teilerfremde Mehrfache einer Gesamtfrequenzschrittgröße für den Funkempfänger sind.

2. Mehrfach-Überlagerungsfunkempfänger nach Anspruch 1, umfassend einen ersten Frequenzfilter (21), der an einen Eingang (20) gekoppelt ist und eine Bandbreite hat, die größer ist als die des empfangenen Signals (20).

3. Mehrfach-Überlagerungsfunkempfänger nach Anspruch 1 oder 2, wobei die Einschleifensynthesizer (31-38) eine gemeinsame Referenzfrequenzquelle (30) haben.

4. Mehrfach-Überlagerungsfunkempfänger nach Anspruch 1, 2 oder 3, in dem es zwei örtliche Oszillatoren gibt.

5. Verfahren zum Empfangen eines Funksignals mit einem Mehrfach-Überlagerungsfunkempfänger, umfassend die Schritte des Wandelns eines Eingangssignals in mindestens eine erste und eine zweite Zwischenfrequenz durch Mischen des Signals mit Signalen vom ersten bzw. zweiten örtlichen Oszillator, wobei es sich bei den örtlichen Oszillatoren um Einschleifenoszillatoren handelt, die in vorherbestimmten Mindestfrequenzschrittgrößen abgestimmt werden können und weiter umfassend die Technik des Bestimmens der Frequenzschrittgrößen des ersten und des zweiten örtlichen Oszillators, indem sie zu nicht aufeinanderfolgenden teilerfremden Mehrfachen einer Gesamtfrequenzschrittgröße für den Funkempfänger gemacht werden.

**Revendications**

1. Récepteur radio à multiples convertisseurs comportant au moins un premier et un deuxième oscillateurs locaux (22, 25) pour convertir un signal d'entrée (20) en une première et deuxième fréquences intermédiaires respectives, dans lequel chaque oscillateur local est un synthétiseur à une seule boucle (30-38) qui peut être accordé dans des tailles de pas en fréquence minimum prédéterminees et les tailles de pas en fréquence minimum dans les deux oscillateurs sont des multiples mutuellement premiers entre eux non successifs d'une taille de pas en fréquence globale pour le récepteur radio.

2. Récepteur radio à multiples convertisseurs selon la revendication 1 comportant un premier filtre de fréquences (21) accouplé à une entrée (20) et possédant une largeur de bande supérieure à celle du signal (20) qui est reçu.

3. Récepteur radio à multiples convertisseurs selon la revendication 1 ou 2 dans lequel les synthétiseurs à une seule boucle (31-38) partagent une source de fréquences de référence commune (30).

4. Récepteur radio à multiples convertisseurs selon la revendication 1, 2 ou 3 dans lequel il y a deux oscillateurs locaux.

5. Procédé pour recevoir un signal radio avec un récepteur radio à multiples convertisseurs comportant les étapes consistant à convertir un signal d'entrée en au moins une première et une deuxième fréquences intermédiaires en mélangeant le signal à des signaux provenant respectivement d'un premier et d'un deuxième oscillateurs locaux, dans lequel les oscillateurs locaux sont des synthétiseurs à une seule boucle qui peuvent être accordés dans des tailles de pas en fréquence minimum prédéterminees, et comportant en outre l'art de déterminer les tailles de pas en fréquence des premier et deuxième oscillateurs locaux en en faisant des multiples mutuellement premiers entre eux non successifs d'une taille de pas en fréquence globale pour le récepteur radio.

## FIG. 1
### SUPERHETERODYNE RADIO RECEIVER

## FIG. 2
### DOUBLE-CONVERSION RADIO RECEIVER

## FIG. 3
### SINGLE-LOOP SYNTHESISER

START

if1 = fa

lo1 = if1 + f

Is lo1
an integer multiple
of px△?

no → if1 = if1 + qx△

if1 > fb ?

no

yes → STOP and report an error

yes

k = lo1 / (px△)

Is 2nd
local oscillator
frequency higher
than 1st i.f?

yes → lo2 = if1 + if2

no → lo2 = if1 - if2

l = lo2 / (qx△)

OUTPUT k and l

STOP

# FIG. 4

FLOWCHART FOR
CALCULATION OF k AND l

FIG. 5

FLOWCHART FOR CALCULATION
OF k AND l BY INTEGER ARITHMETIC

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5610559 A

- US 5390346 A